# EUROPEAN PATENT APPLICATION

(11) **EP 4 528 937 A1**
(43) Date of publication of application: **26.03.2025**
(21) Application number: 23829386.4
(22) Date of filing: 06.02.2023
(51) Int. Cl.: H01R 13/05, H01R 12/70, H01R 12/58

(54) **CABLE ASSEMBLY, CIRCUIT BOARD, CONNECTING STRUCTURE AND ELECTRONIC DEVICE**

(30) Priority: 29.06.2022 CN 202210747601
(71) Applicant: ZTE Corporation, Shenzhen, Guangdong 518057 (CN)
(72) Inventor: LIU, Shitao, Shenzhen, Guangdong 518057 (CN); BI, Yu, Shenzhen, Guangdong 518057 (CN); YI, Bi, Shenzhen, Guangdong 518057 (CN); ZHANG, Xindan, Shenzhen, Guangdong 518057 (CN)
(74) Representative: Savi, Massimiliano
(86) International application number: PCT/CN2023/074665
(87) International publication number: WO 2024/001193

(57) **Abstract**

The present application provides a cable assembly, a circuit board, a connecting structure, and an electronic device. The cable assembly (100) comprises a cable (110), a first connecting member, and a second connecting member. The cable (110) comprises a signal line (101) and a shielding layer (102). The first connecting member comprises a first connecting portion (121) and a second connecting portion (122). The first connecting portion (121) is connected to the signal line (101), and the second connecting portion (122) can be configured to be elastically connected to a circuit board (200) provided with a first conductive interface (210). The second connecting member comprises a third connecting portion (131) and a fourth connecting portion (132). The third connecting portion (131) is connected to the shielding layer (102), both the second connecting portion (122) and the fourth connecting portion (132) can be elastically deformed, and the fourth connecting portion (132) can be configured to be elastically connected to the circuit board (200) provided with a second conductive interface (220).

## Description

### CROSS-REFERENCE TO RELATED APPLICATION

The present disclosure is filed on the basis of Chinese Patent Application No. 202210747601.3 filed on June 29, 2022, and claims priority to the Chinese Patent Application, the entire contents of which are incorporated herein by reference.

### TECHNICAL FIELD

The present disclosure relates to the field of electronic technologies, and more particularly, to a cable assembly, a circuit board, a connection structure, and an electronic device.

### BACKGROUND

Currently, most cable assemblies use a structure in which a socket fits a cable. However, in the future 112G/224G system, a circuit board loss is increasing, and the socket has a certain height, which are not conducive to heat dissipation of the system. In addition, as the socket is arranged on the cable assembly, an end of the cable is connected to the socket, and then the socket is connected to a circuit board, a contact interface increases, thereby increasing impedance discontinuity points and limiting bandwidth of signal transmission. In the related art, the cable is directly connected to a Printed Circuit Board (PCB) through a fisheye structure to reduce the use of socket. However, since the cable is directly connected to the PCB through this fisheye structure, the component of the fisheye structure cannot be detached from the PCB, which raises maintenance and rework costs.

### SUMMARY

Embodiments of the present disclosure provide a cable assembly, a circuit board, a connection structure, and an electronic device.

According to a first aspect of the present disclosure, an embodiment provides a cable assembly, including: a cable, including a signal line and a shielding layer; a first connecting member, including a first connecting portion and a second connecting portion, where the first connecting portion is connected to the signal line, the second connecting portion is elastically deformable, and the second connecting portion is configured to be elastically connected to a circuit board provided with a first conductive interface; and a second connecting member, including a third connecting portion and a fourth connecting portion, where the third connecting portion is connected to the shielding layer, the fourth connecting portion is elastically deformable, and the fourth connecting portion is configured to be elastically connected to the circuit board provided with a second conductive interface.

According to a second aspect of the present disclosure, an embodiment provides a circuit board, including: a first conductive interface, configured to be connected to the cable assembly according to the first aspect; and a second conductive interface, configured to be connected to the cable assembly.

According to a third aspect of the present disclosure, an embodiment provides a connection structure, including: a cable assembly, including a cable, a first connecting member, and a second connecting member, where the cable includes a signal line and a shielding layer, the first connecting member includes a first connecting portion and a second connecting portion, the first connecting portion is connected to the signal line, the second connecting portion is elastically deformable, the second connecting member includes a third connecting portion and a fourth connecting portion, the third connecting portion is connected to the shielding layer, and the fourth connecting portion is elastically deformable; and a circuit board, including a first conductive interface and a second conductive interface, where the first conductive interface is elastically connected to the second connecting portion, and the second conductive interface is elastically connected to the fourth connecting portion.

According to a fourth aspect of the present disclosure, an embodiment provides an electronic device, including the cable assembly according to the first aspect, or including the circuit board according to the second aspect, or including the connection structure according to the third aspect.

### BRIEF DESCRIPTION OF DRAWINGS

FIG. 1 is a schematic structural diagram of a connection structure in the related art;
FIG. 2 is a schematic structural diagram of a cable assembly according to an embodiment of the present disclosure;
FIG. 3 is a schematic structural diagram of a first connecting member according to an embodiment of the present disclosure;
FIG. 4 is schematic diagram of elastic deformation directions of a first connecting sub-portion and a second connecting sub-portion according to an embodiment of the present disclosure;
FIG. 5 is a schematic structural diagram of a side surface of FIG. 4;
FIG. 6 is a schematic structural diagram of a cable assembly according to another embodiment of the present disclosure;
FIG. 7 is a schematic structural diagram of a cable assembly according to another embodiment of the present disclosure;
FIG. 8 is a schematic structural diagram of a circuit board according to an embodiment of the present disclosure;
FIG. 9 is a schematic structural diagram of a circuit board according to another embodiment of the present disclosure;
FIG. 10 is a schematic structural diagram of a connection structure according to an embodiment of the present disclosure;
FIG. 11 is a schematic diagram of a performance simulation result of a connection structure according to an embodiment of the present disclosure;
FIG. 12 is a schematic diagram of an application scenario of a cable assembly according to an example of the present disclosure; and
FIG. 13 is a schematic diagram of an application scenario of a cable assembly according to another example of the present disclosure.

### DETAILED DESCRIPTION

To make the objects, technical schemes, and advantages of the present disclosure clear, the present disclosure is described in further detail in conjunction with accompanying drawings and embodiments. It should be understood that the specific embodiments described herein are merely used for illustrating the present disclosure, and are not intended to limit the present disclosure.

It is to be noted, although logical orders have been shown in the flowcharts, in some cases, the steps shown or described may be executed in an order different from the orders as shown in the flowcharts. In the description of the specification, claims and accompanying drawings, the term "plurality of" (or multiple) means at least two, the term such as "greater than", "less than", "exceed" or variants thereof prior to a number or series of numbers is understood to not include the number adjacent to the term. The term "at least" prior to a number or series of numbers is understood to include the number adjacent to the term "at least", and all subsequent numbers or integers that could logically be included, as clear from context. If used herein, the terms such as "first", "second", and the like are merely used for distinguishing technical features, and are not intended to indicate or imply relative importance, or implicitly point out the number of the indicated technical features, or implicitly point out the precedence order of the indicated technical features.

The present disclosure provides a cable assembly, a circuit board, a connection structure, and an electronic device. An elastically-deformable second connecting portion is arranged on a first connecting member, and an elastically-deformable fourth connecting portion is arranged on a second connecting member, such that after the second connecting portion is elastically connected to a first conductive interface of the circuit board and the fourth connecting portion is elastically connected to a second conductive interface of the circuit board, the cable assembly can be detachable from the circuit board, which reduces production costs of maintenance and rework. In addition, the first connecting member and the second connecting member can be directly connected to the circuit board without having to arrange a socket on the cable assembly, which reduces the height of the cable assembly, to facilitate heat dissipation of the system. Meanwhile, impedance discontinuity points generated between the circuit board and the socket and impedance discontinuity points generated between the socket and the cable assembly are reduced, thereby improving bandwidth of signal transmission.

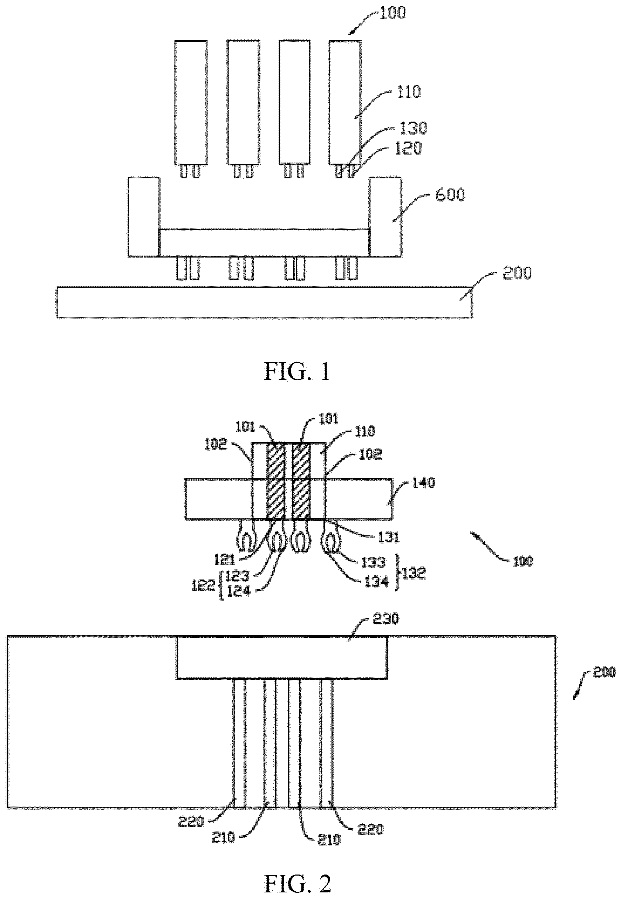

It should be noted that, as shown in FIG. 1, at present, most cable assemblies 100 use a structure in which a socket 600 fits a cable 110. To be specific, the socket 600 is arranged on the cable assembly 100, an end of the cable 110 is connected to the socket 600, and then the socket 600 is connected to a circuit board 200. As a result, a contact interface increases, thereby increasing impedance discontinuity points and limiting bandwidth of signal transmission. In view of the above, in the related art, the cable 110 is directly connected to a PCB through a fisheye structure to reduce the use of socket 600. However, as the cable 110 is directly connected to the PCB through the fisheye structure, a device of the fisheye structure cannot be detached from the PCB, which increases production costs of maintenance and rework.

Based on the foregoing analysis, embodiments of the present disclosure will be further described below in conjunction with the accompanying drawings.

FIG. 2 is a schematic structural diagram of a cable assembly according to an embodiment of the present disclosure. To facilitate description of a structural principle of the cable assembly, FIG. 2 additionally shows a circuit board 200 for illustration. The cable assembly 100 includes a cable 110, a first connecting member (not marked in the figure), and a second connecting member (not marked in the figure). The cable 110 includes a signal line 101 and a shielding layer 102. The first connecting member includes a first connecting portion 121 and a second connecting portion 122. The first connecting portion 121 is connected to the signal line 101. The second connecting portion 122 is elastically deformable, and may be configured to be elastically connected to the circuit board 200 provided with a first conductive interface 210. The second connecting member includes a third connecting portion 131 and a fourth connecting portion 132. The third connecting portion 131 is connected to the shielding layer 102. The fourth connecting portion 132 is elastically deformable, and may be configured to be elastically connected to the circuit board 200 provided with a second conductive interface 220.

In this embodiment, the elastically-deformable second connecting portion 122 is arranged on the first connecting member, and the elastically-deformable fourth connecting portion 132 is arranged on the second connecting member, such that after the second connecting portion 122 is elastically connected to the first conductive interface 210 of the circuit board 200 and the fourth connecting portion 132 is elastically connected to the second conductive interface 220 of the circuit board 200, the cable assembly 100 can be detachable from the circuit board 200, which makes it easy to replace and repair, and reduces production costs of maintenance and rework. In addition, the first connecting member and the second connecting member can be directly connected to the circuit board 200 for signal transmission without having to arrange a socket on the cable assembly 100, which reduces the height of the cable assembly 100, to facilitate heat dissipation of the system. Meanwhile, impedance discontinuity points generated between the circuit board 200 and the socket and impedance discontinuity points generated between the socket and the cable assembly 100 are reduced, thereby improving bandwidth of signal transmission.

In an implementation, there may be a plurality of manners for connecting the first connecting portion 121 to the signal line 101 and connecting the third connecting portion 131 to the shielding layer 102, for example, welding (such as laser welding) or injection molding, which are not specifically limited herein.

In an implementation, the first conductive interface 210 and the second conductive interface 220 are both plated through holes, and a finished hole size of the first conductive interface 210 and a finished hole size of the second conductive interface 220 may be less than 0.5 mm. For example, the finished hole size is 0.3 mm, 0.2 mm, or other values, which will not be enumerated herein. It can be understood that the plated through hole is a hole formed by chemically plating a thin layer of copper on an inner wall of a hole between a top layer of the circuit board 200 and a bottom layer of the circuit board 200, which can connect the top layer and the bottom layer of the circuit board 200 to each other.

In an implementation, the first connecting member and the second connecting member may be cylindrical structures, or may be in other shapes, which are not specifically limited herein.

In an implementation, the shielding layer 102 may be made of a metal material or a semi-conductive material. For example, the metal material may be a metal wire woven into a mesh, or may be a metal film. Moreover, the shielding layer 102 of the cable 110 may or may not be wrapped with an insulating medium. When the shielding layer 102 is wrapped with an insulating medium (i.e., an insulating layer), the shielding layer 102 of the cable 110 needs to be exposed for connection to the third connecting portion 131. This isolates electromagnetic interference between cables 110 and ensures shielding performance. In addition, the shielding layer 102 is equipotential with the shielded cable 110 and is in contact with the insulating layer, thereby avoiding partial discharge between the cable 110 and the insulating layer.

In an implementation, the shielding layer 102 may be a single shielding layer or a plurality of shielding layers. The single shielding layer may be a single shielding mesh or a shielding film. The plurality of shielding layers may be a plurality of shielding meshes or shielding films.

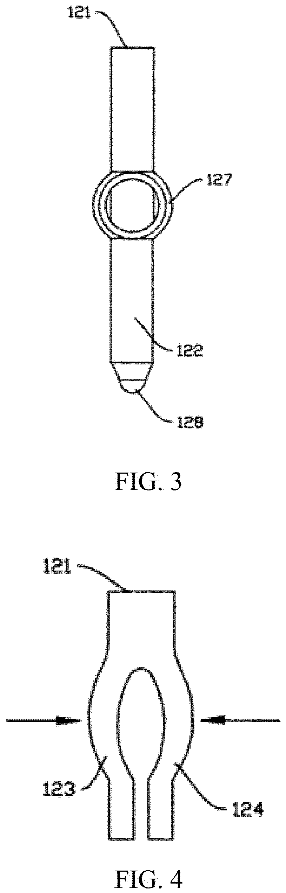

In an implementation, the second connecting portion and the fourth connecting portion are both provided with a guide structure. The guide structure is chamfered or tapered, or may be in other guiding shapes, which may be set according to actual needs, and is not specifically limited herein. In addition, the guide structure is configured for guiding, and a shape of the guide structure does not affect its own conduction performance. A guide structure 128 of the second connecting portion 122 is shown in FIG. 3.

In an embodiment, as shown in FIG. 2, the second connecting portion 122 may include a first connecting sub-portion 123 and a second connecting sub-portion 124 which are arranged oppositely. The fourth connecting portion 132 may include a third connecting sub-portion 133 and a fourth connecting sub-portion 134 which are arranged oppositely. The first connecting sub-portion 123, the second connecting sub-portion 124, the third connecting sub-portion 133, and the fourth connecting sub-portion 134 are all elastically deformable.

In an implementation, the first connecting sub-portion 123, the second connecting sub-portion 124, the third connecting sub-portion 133, and the fourth connecting sub-portion 134 are all provided with a guide structure. The guide structure is chamfered or tapered, or may be in other guiding shapes, which may be set according to actual needs, and is not specifically limited herein. In addition, the guide structure is configured for guiding, and a shape of the guide structure does not affect its own conduction performance.

Based on the foregoing embodiment, as shown in FIG. 2, FIG. 4, and FIG. 5, when the first connecting sub-portion 123 and the second connecting sub-portion 124 are in an elastically-deformed state, a distance between the first connecting sub-portion 123 and the second connecting sub-portion 124 is shortened, and when the third connecting sub-portion 133 and the fourth connecting sub-portion 134 are in an elastically-deformed state, a distance between the third connecting sub-portion 133 and the fourth connecting sub-portion 134 is shortened. FIG. 4 is a schematic diagram of elastic deformation directions of the first connecting sub-portion 123 and the second connecting sub-portion 124.

In another embodiment, as shown in FIG. 3, the second connecting portion 122 is provided with a first elastic structure 127 communicated with the first connecting portion 121. The fourth connecting portion (not shown in the figure) is provided with a second elastic structure (not shown in the figure) communicated with the third connecting portion (not shown in the figure). When the second connecting portion 122 is elastically connected to the first conductive interface (not shown in the figure) and the fourth connecting portion is elastically connected to the second conductive interface (not shown in the figure), the first elastic structure 127 and the second elastic structure are both in an elastically-deformed state.

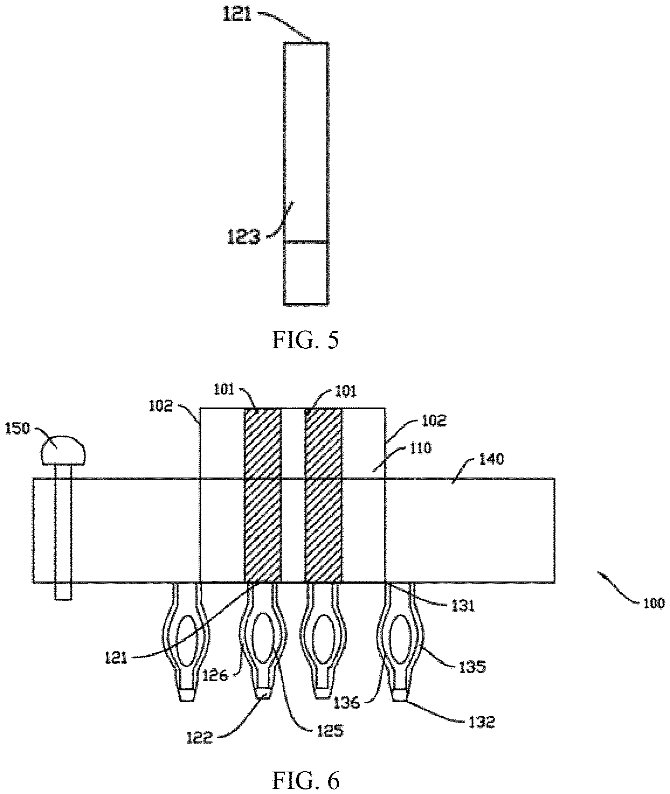

In another embodiment, as shown in FIG. 6, the first connecting member includes a first connecting arm 125 communicating the first connecting portion 121 with the second connecting portion 122 and a second connecting arm 126 communicating the first connecting portion 121 with the second connecting portion 122. The second connecting member includes a third connecting arm 135 communicating the third connecting portion 131 with the fourth connecting portion 132 and a fourth connecting arm 136 communicating the third connecting portion 131 with the fourth connecting portion 132.

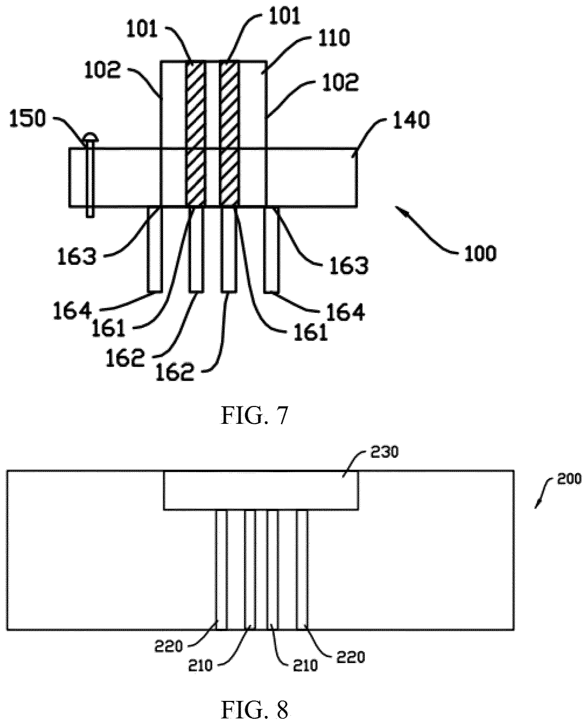

In an embodiment, as shown in FIG. 7, the cable assembly 100 includes a cable 110, a first connecting member (not marked in the figure), and a second connecting member (not marked in the figure). The cable 110 includes a signal line 101 and a shielding layer 102. The first connecting member includes a fifth connecting portion 161 and a sixth connecting portion 162. The fifth connecting portion 161 is connected to the signal line 101. The sixth connecting portion 162 is not elastically deformable, and may be configured to be connected to a circuit board 200 provided with a first conductive interface 210. The second connecting member includes a seventh connecting portion 163 and an eighth connecting portion 164. The seventh connecting portion 163 is connected to the shielding layer 102. The eighth connecting portion 164 is not elastically deformable, and may be configured to be connected to the circuit board 200 provided with a second conductive interface 220. The cable assembly 100 may include a fixing piece 140 provided with a screw hole, and the fixing piece 140 is fixed to the circuit board by a screw 150, which is not specifically limited in this embodiment of the present disclosure.

In an embodiment, as shown in FIG. 2, the cable assembly 100 includes a fixing piece 140. The fixing piece 140 includes a first fixing portion (not marked in the figure) and a second fixing portion (not marked in the figure). The first fixing portion is connected at a connection between the first connecting portion 121 and the signal line 101, and the second fixing portion is connected at a connection between the third connecting portion 131 and the shielding layer 102. The cable assembly 100 can be stably connected to the circuit board 200 by the fixing piece 140. There are many ways in which the cable assembly 100 can be stably connected to the circuit board 200 by the fixing piece 140, for example, connected by structures such as snaps, rivets, or mortise and tenon joints, such that the cable assembly 100 can be detachable from the circuit board 200. As shown in FIG. 6 and FIG. 7, a screw hole may be formed in the fixing piece 140, and the fixing piece 140 may be fixed to the circuit board by a screw 150, which is not specifically limited herein.

It can be understood that the fixing piece 140 has a smaller thickness than the socket, and the thickness of the fixing piece 140 may be set according to actual needs, which is not specifically limited herein.

In an implementation, the fixing piece 140 may be in a shape of a polygon, such as a triangle, a square, a rectangle, a rhombus, a trapezoid, or other shapes, which will not be enumerated herein.

In addition, as shown in FIG. 8, another embodiment of the present disclosure provides a circuit board. The circuit board 200 includes a first conductive interface 210 and a second conductive interface 220. Both the first conductive interface 210 and the second conductive interface 220 may be connected to the cable assembly in the foregoing embodiment to achieve signal transmission. Therefore, the circuit board 200 has beneficial effects brought by the cable assembly in any one of the foregoing embodiments. To be specific, the elastically-deformable second connecting portion is arranged on the first connecting member in the cable assembly, and the elastically-deformable fourth connecting portion is arranged on the second connecting member in the cable assembly, such that the cable assembly can be elastically connected to the first conductive interface 210 of the circuit board 200 and elastically connected to the second conductive interface 220 of the circuit board 200. After the cable assembly is connected to the circuit board 200, the cable assembly can be detachable from the circuit board 200, which reduces production costs of maintenance and rework. In addition, the first connecting member and the second connecting member in the cable assembly can be directly connected to the circuit board 200 without having to arrange a socket on the cable assembly, which reduces the height of the cable assembly, to facilitate heat dissipation of the system. Meanwhile, a contact interface is reduced, and thus impedance discontinuity points generated between the circuit board 200 and the socket and impedance discontinuity points generated between the socket and the cable assembly are reduced, improving bandwidth of signal transmission.

In an embodiment, as shown in FIG. 8, the first conductive interface 210 and the second conductive interface 220 are both filled with an elastically-deformable conductive material, and the first conductive interface 210 and the second conductive interface 220 can be elastically connected to the cable assembly through the conductive material.

In an implementation, the conductive material may be conductive rubber, conductive silver glue, metal filaments, fuzz buttons, metal springs, or the like, or may be other conductive and elastic materials, which is not specifically limited herein. In addition, the conductive material may have a conductivity greater than 100 S/m. For example, the conductivity may be 101 S/m, 120 S/m, or other values, which will not be enumerated herein.

It can be understood that the conductive material has desirable elasticity, and therefore a satisfactory contact force is achieved between the first conductive interface 210 and the cable 110, and between the second conductive interface 220 and the cable 110, and stability of electrical contact between the first conductive interface 210 and the cable 110 and stability of electrical contact between the second conductive interface 220 and the cable 110 can be ensured.

In an embodiment, as shown in FIG. 8, the circuit board 200 is provided with an avoidance groove 230. The first conductive interface 210 and the second conductive interface 220 are both connected to the avoidance groove 230. A shape of the avoidance groove 230 is not limited. For example, a cross section of the avoidance groove 230 may be in a shape of a polygon, such as a triangle, a square, a rectangle, a rhombus, a trapezoid, or other shapes, which will not be enumerated herein.

Based on the foregoing embodiment, the avoidance groove includes a first avoidance port and a second avoidance port. The first conductive interface is connected to the first avoidance port, and the second conductive interface is connected to the second avoidance port, which are not specifically limited herein.

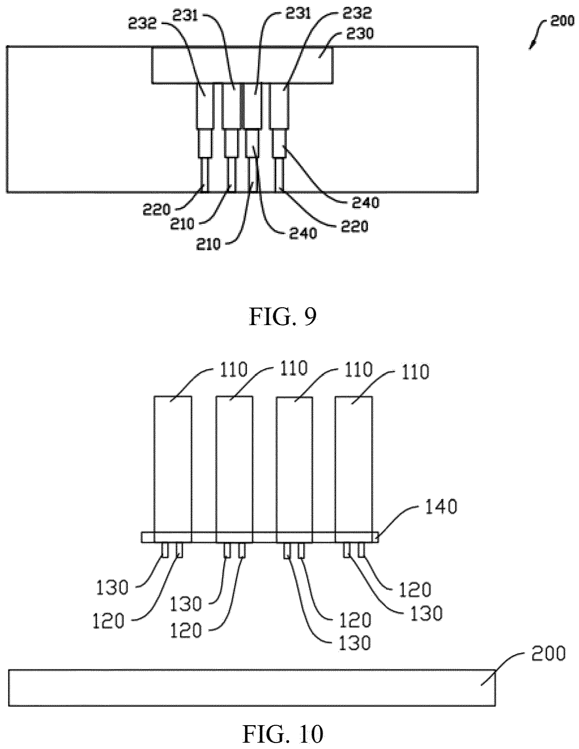

In another embodiment, as shown in FIG. 9, a transition hole 240 may be arranged between the first avoidance port 231 and the first conductive interface 210, and between the second avoidance port 232 and the second conductive interface 220, respectively. The first avoidance port 231 can function to avoid the second connecting portion 122 and guide the second connecting portion 122 to be inserted into the first conductive interface 210. The second avoidance port 232 can function to avoid the fourth connecting portion 132 and guide the fourth connecting portion 132 to be inserted into the first conductive interface 210. The transition holes 240 may be filled with an elastically-deformable conductive material, and the first conductive interface 210 and the second conductive interface 220 may not be filled with an elastically-deformable conductive material.

In addition, as shown in FIG. 2, another embodiment of the present disclosure provides a connection structure. The connection structure includes a cable assembly 100 and a circuit board 200. The cable assembly 100 includes a cable 110, a first connecting member (not marked in the figure), and a second connecting member (not marked in the figure). The cable 110 includes a signal line 101 and a shielding layer 102. The first connecting member includes a first connecting portion 121 and a second connecting portion 122, the first connecting portion 121 is connected to the signal line 101, and the second connecting portion 122 is elastically deformable. The second connecting member includes a third connecting portion 131 and a fourth connecting portion 132, the third connecting portion 131 is connected to the shielding layer 102, and the fourth connecting portion 132 is elastically deformable. The circuit board 200 includes a first conductive interface 210 and a second conductive interface 220.

When the first conductive interface 210 is elastically connected to the second connecting portion 122 and the second conductive interface 220 is elastically connected to the fourth connecting portion 132, the second connecting portion 122 and the fourth connecting portion 132 are both in an elastically-deformed state.

In this embodiment, the elastically-deformable second connecting portion 122 is arranged on the first connecting member, and the elastically-deformable fourth connecting portion 132 is arranged on the second connecting member, such that after the second connecting portion 122 is elastically connected to the first conductive interface 210 of the circuit board 200 and the fourth connecting portion 132 is elastically connected to the second conductive interface 220 of the circuit board 200, the cable assembly 100 can be detachable from the circuit board 200, which reduces production costs of maintenance and rework. In addition, the first connecting member and the second connecting member can be directly connected to the circuit board 200 for signal transmission without having to arrange a socket on the cable assembly 100, which reduces the height of the cable assembly 100, to facilitate heat dissipation of the system. Meanwhile, impedance discontinuity points generated between the circuit board 200 and the socket and impedance discontinuity points generated between the socket and the cable assembly 100 are reduced, thereby improving bandwidth of signal transmission.

It can be understood that due to a skin effect, after the second connecting portion 122 is inserted into the first conductive interface 210 and the fourth connecting portion 132 is inserted into the second conductive interface 220, even though the second connecting portion 122 and the fourth connecting portion 132 are elastically deformed, Signal Integrity (SI) performance is not affected. In addition, signal transmission bandwidth is affected by an aperture of the first conductive interface 210 and an aperture of the second conductive interface 220. However, provided that the second connecting portion 122 is in contact with the first conductive interface 210 and the fourth connecting portion 132 is in contact with the second conductive interface 220, the signal transmission bandwidth will not be affected. Signals are unevenly distributed on the first connecting member and the second connecting member. A large amount of the signals are concentrated on the surface of the first connecting member and the surface of the second connecting member, and the closer to the center of the first connecting member and the center of the second connecting member, the less signals there are. Such a phenomenon is referred to as the skin effect.

In an embodiment, as shown in FIG. 2, the cable assembly 100 includes a fixing piece 140. The fixing piece 140 includes a first fixing portion (not marked in the figure) and a second fixing portion (not marked in the figure). The first fixing portion is connected at a connection between the first connecting portion 121 and the signal line 101, and the second fixing portion is connected at a connection between the third connecting portion 131 and the shielding layer 102. The cable assembly 100 can be stably connected to the circuit board 200 by the fixing piece 140. There are many ways in which the cable assembly 100 can be stably connected to the circuit board 200 by the fixing piece 140, for example, connected by structures such as snaps, rivets, or mortise and tenon joints, such that the cable assembly 100 can be detachable from the circuit board 200. As shown in FIG. 6 and FIG. 7, a screw hole may be formed in the fixing piece 140, and the fixing piece 140 may be fixed to the circuit board by a screw 150, which is not specifically limited herein.

Based on the foregoing embodiment, as shown in FIG. 2, in an embodiment, the circuit board 200 is provided with an avoidance groove 230. The first conductive interface 210 and the second conductive interface 220 are both connected to the avoidance groove 230. The avoidance groove 230 is matched with the fixing piece 140 in size, and the fixing piece 140 can be installed in the avoidance groove 230 to reduce the height of the cable assembly 100, to facilitate heat dissipation of the system.

In an implementation, the avoidance groove 230 has the same thickness as the fixing piece 140, and the fixing piece 140 can be completely embedded in the avoidance groove 230 to reduce the height of the cable assembly 100 caused by the fixing piece 140, which facilitates heat dissipation of the system.

In an embodiment, as shown in FIG. 2, the cable assembly 100 includes a cable 110, a first connecting member, and a second connecting member. The cable 110 includes a signal line 101 and a shielding layer 102. The first connecting member includes a first connecting portion 121 and a second connecting portion 122. The second connecting member includes a third connecting portion 131 and a fourth connecting portion 132. The first connecting portion 121 is connected to the signal line 101, the third connecting portion 131 is connected to the shielding layer 102, and the second connecting portion 122 and the fourth connecting portion 132 are both elastically deformable. The circuit board 200 includes a first conductive interface 210 and a second conductive interface 220. When the second connecting portion 122 is connected to the first conductive interface 210, and the fourth connecting portion 132 is connected to the second conductive interface 220, the second connecting portion 122 and the fourth connecting portion 132 are both in an elastically-deformed state. The first conductive interface 210 and the second conductive interface 220 may not be filled with an elastically-deformable conductive material, which is not specifically limited herein.

It can be understood that, since the second connecting portion 122 and the fourth connecting portion 132 have desirable elasticity, a satisfactory contact force is achieved between the first conductive interface 210 and the second connecting portion 122, and between the second conductive interface 220 and the fourth connecting portion 132, and stability of electrical contact between the first conductive interface 210 and the second connecting portion 122 and stability of electrical contact between the second conductive interface 220 and the fourth connecting portion 132 can be ensured.

In this embodiment, the elastically-deformable second connecting portion 122 is arranged on the first connecting member, and the elastically-deformable fourth connecting portion 132 is arranged on the second connecting member, such that after the second connecting portion 122 is elastically connected to the first conductive interface 210 of the circuit board 200 and the fourth connecting portion 132 is elastically connected to the second conductive interface 220 of the circuit board 200, the cable assembly 100 can be detachable from the circuit board 200, which reduces production costs of maintenance and rework. In addition, the first connecting member and the second connecting member can be directly connected to the circuit board 200 for signal transmission without having to arrange a socket on the cable assembly 100, which reduces the height of the cable assembly 100, to facilitate heat dissipation of the system. Meanwhile, impedance discontinuity points generated between the circuit board 200 and the socket and impedance discontinuity points generated between the socket and the cable assembly 100 are reduced, thereby improving bandwidth of signal transmission.

Based on the foregoing embodiment, in an embodiment, as shown in FIG. 2, the second connecting portion 122 may include a first connecting sub-portion 123 and a second connecting sub-portion 124 which are arranged oppositely. The fourth connecting portion 132 may include a third connecting sub-portion 133 and a fourth connecting sub-portion 134 which are arranged oppositely. The first connecting sub-portion 123, the second connecting sub-portion 124, the third connecting sub-portion 133, and the fourth connecting sub-portion 134 are all elastically deformable. When the first connecting sub-portion 123 and the second connecting sub-portion 124 are both connected to the first conductive interface 210, and the third connecting sub-portion 133 and the fourth connecting sub-portion 134 are both connected to the second conductive interface 220, the first connecting sub-portion 123, the second connecting sub-portion 124, the third connecting sub-portion 133, and the fourth connecting sub-portion 134 are all in an elastically-deformed state, that is, a distance between the first connecting sub-portion 123 and the second connecting sub-portion 124 is shortened, and a distance between the third connecting sub-portion 133 and the fourth connecting sub-portion 134 is shortened.

In an implementation, the first connecting sub-portion 123, the second connecting sub-portion 124, the third connecting sub-portion 133, and the fourth connecting sub-portion 134 may all be arc-shaped or in other shapes, which are not specifically limited herein.

Arc-shaped edges of the first connecting sub-portion 123 and the second connecting sub-portion 124 are elastic and guiding. When the first connecting sub-portion 123 and the second connecting sub-portion 124 are in contact with the first conductive interface 210, since a cross-sectional area of a bottom of the first connecting sub-portion 123 and a bottom of the second connecting sub-portion 124 is less than a cross-sectional area of the first conductive interface 210, the first connecting sub-portion 123 and the second connecting sub-portion 124 can be guided into the first conductive interface 210. In a process of gradually inserting the first connecting sub-portion 123 and the second connecting sub-portion 124 into the first conductive interface 210, when the cross-sectional area of the first conductive interface 210 is less than the cross-sectional area of the first connecting sub-portion 123 and the second connecting sub-portion 124, the first connecting sub-portion 123 and the second connecting sub-portion 124 are elastically deformed such that the distance between the first connecting sub-portion 123 and the second connecting sub-portion 124 is shortened, until the first connecting sub-portion 123 and the second connecting sub-portion 124 are completely inserted into the first conductive interface 210. In this case, the first connecting sub-portion 123 and the second connecting sub-portion 124 are electrically connected to the first conductive interface 210. Similarly, a process of connecting the third connecting sub-portion 133 and the fourth connecting sub-portion 134 to the second conductive interface 220 is similar thereto, and details are not described herein again.

In another embodiment, as shown in FIG. 7 and FIG. 8, the first connecting member includes a fifth connecting portion 161 and a sixth connecting portion 162, and the second connecting member includes a seventh connecting portion 163 and an eighth connecting portion 164. The fifth connecting portion 161 is connected to the signal line 101, and the seventh connecting portion 163 is connected to the shielding layer 102. The sixth connecting portion 162 and the eighth connecting portion 164 are not elastically deformable. The first conductive interface 210 and the second conductive interface 220 are both filled with an elastically-deformable conductive material. The first conductive interface 210 is elastically connected to the sixth connecting portion 162 through the conductive material, and the second conductive interface 220 is elastically connected to the eighth connecting portion 164 through the conductive material, to achieve signal transmission.

It can be understood that, since the conductive material has desirable elasticity, a satisfactory contact force is achieved between the first conductive interface 210 and the sixth connecting portion 162, and between the second conductive interface 220 and the eighth connecting portion 164, and stability of electrical contact between the first conductive interface 210 and the sixth connecting portion 162 and stability of electrical contact between the second conductive interface 220 and the eighth connecting portion 164 can be ensured. Meanwhile, the sixth connecting portion 162 and the eighth connecting portion 164 can be protected from damage.

In this embodiment, the first conductive interface 210 and the second conductive interface 220 are filled with the elastically-deformable conductive material, such that after the sixth connecting portion 162 is elastically connected to the first conductive interface 210 of the circuit board 200 and the eighth connecting portion 164 is elastically connected to the second conductive interface 220 of the circuit board 200, the cable assembly 100 can be detachable from the circuit board 200, which reduces production costs of maintenance and rework. In addition, the first connecting member and the second connecting member can be directly connected to the circuit board 200 for signal transmission without having to arrange a socket on the cable assembly 100, which reduces the height of the cable assembly 100, to facilitate heat dissipation of the system. Meanwhile, impedance discontinuity points generated between the circuit board 200 and the socket and impedance discontinuity points generated between the socket and the cable assembly 100 are reduced, thereby improving bandwidth of signal transmission.

In another embodiment, as shown in FIGs. 6 and 9, the first connecting member includes a first connecting arm 125 communicating the first connecting portion 121 with the second connecting portion 122 and a second connecting arm 126 communicating the first connecting portion 121 with the second connecting portion 122. The second connecting member includes a third connecting arm 135 communicating the third connecting portion 131 with the fourth connecting portion 132 and a fourth connecting arm 136 communicating the third connecting portion 131 with the fourth connecting portion 132. The first conductive interface 210 and the second conductive interface 220 are both filled with an elastically-deformable conductive material. The first conductive interface 210 is elastically connected to the second connecting portion 122 through the conductive material, and the second conductive interface 220 is elastically connected to the fourth connecting portion 132 through the conductive material, to achieve signal transmission.

It can be understood that the first conductive interface 210 can accommodate the first connecting arm 125 and the second connecting arm 126, and the second conductive interface 220 can accommodate the third connecting arm 135 and the fourth connecting arm 136. When the first conductive interface 210 is elastically connected to the second connecting portion 122 through the conductive material, and the second conductive interface 220 is elastically connected to the fourth connecting portion 132 through the conductive material, the first connecting arm 125, the second connecting arm 126, the third connecting arm 135, and the fourth connecting arm 136 can be protected by the elastically-deformable conductive material from damage.

It can be understood that, since the conductive material has desirable elasticity, a satisfactory contact force is achieved between the first conductive interface 210 and the second connecting portion 122, and between the second conductive interface 220 and the fourth connecting portion 132, and stability of electrical contact between the first conductive interface 210 and the second connecting portion 122 and stability of electrical contact between the second conductive interface 220 and the fourth connecting portion 132 can be ensured.

In this embodiment, the first conductive interface 210 and the second conductive interface 220 are filled with the elastically-deformable conductive material, such that after the second connecting portion 122 is elastically connected to the first conductive interface 210 of the circuit board 200 and the fourth connecting portion 132 is elastically connected to the second conductive interface 220 of the circuit board 200, the cable assembly 100 can be detachable from the circuit board 200, which reduces production costs of maintenance and rework. In addition, the first connecting member and the second connecting member can be directly connected to the circuit board 200 for signal transmission without having to arrange a socket on the cable assembly 100, which reduces the height of the cable assembly 100, to facilitate heat dissipation of the system. Meanwhile, impedance discontinuity points generated between the circuit board 200 and the socket and impedance discontinuity points generated between the socket and the cable assembly 100 are reduced, thereby improving bandwidth of signal transmission.

In an embodiment, the circuit board is provided with a first avoidance port and a second avoidance port. The first conductive interface is connected to the first avoidance port, and the second conductive interface is connected to the second avoidance port. The first conductive interface and/or the second conductive interface may be filled with an elastically-deformable conductive material. Alternatively, as shown in FIG. 9, a transition hole 240 may be arranged between the first avoidance port 231 and the first conductive interface 210, and between the second avoidance port 232 and the second conductive interface 220, respectively. The first avoidance port 231 can function to avoid the second connecting portion 122 and guide the second connecting portion 122 to be inserted into the first conductive interface 210. The second avoidance port 232 can function to avoid the fourth connecting portion 132 and guide the fourth connecting portion 132 to be inserted into the first conductive interface 210. The transition holes 240 may be filled with an elastically-deformable conductive material, and the first conductive interface 210 and the second conductive interface 220 may not be filled with an elastically-deformable conductive material. When the transition hole 240 is filled with an elastically-deformable conductive material, an aperture of the first avoidance port 231 can accommodate the second connecting portion 122, an aperture of the second avoidance port 232 can accommodate the fourth connecting portion 132, and an aperture of the transition hole 240 may be less than the aperture of the first avoidance port 231 and the aperture of the second avoidance port 232, and greater than an aperture of the first conductive interface 210 and an aperture of the second conductive interface 220, which are not specifically limited herein.

In an embodiment, the cable assembly 100 in the embodiment shown in FIG. 6 may be used in conjunction with the circuit board 200 in the embodiment shown in FIG. 9, which is not specifically limited herein.

In an embodiment, as shown in FIG. 3, the second connecting portion 122 is provided with a first elastic structure 127 communicated with the first connecting portion 121. The fourth connecting portion (not shown in the figure) is provided with a second elastic structure (not shown in the figure) communicated with the third connecting portion (not shown in the figure). When the second connecting portion 122 is elastically connected to the first conductive interface (not shown in the figure) and the fourth connecting portion is elastically connected to the second conductive interface (not shown in the figure), the first elastic structure 127 and the second elastic structure are both in an elastically deformed state. The first conductive interface 210 and the second conductive interface 220 may or may not be filled with an elastically-deformable conductive material, which is not specifically limited herein.

It can be understood that, since the first elastic structure 127 and the second elastic structure both have desirable elasticity, a satisfactory contact force is achieved between the first conductive interface and the second connecting portion 122, and between the second conductive interface and the fourth connecting portion, and stability of electrical contact between the first conductive interface and the second connecting portion 122 and stability of electrical contact between the second conductive interface and the fourth connecting portion can be ensured.

In this embodiment, the first elastic structure 127 is arranged on the second connecting portion 122, and the second elastic structure is arranged on the fourth connecting portion, such that after the second connecting portion 122 is elastically connected to the first conductive interface of the circuit board and the fourth connecting portion is elastically connected to the second conductive interface of the circuit board, the cable assembly can be detachable from the circuit board, which reduces production costs of maintenance and rework. In addition, the first connecting member and the second connecting member can be directly connected to the circuit board for signal transmission without having to arrange a socket on the cable assembly, which reduces the height of the cable assembly, to facilitate heat dissipation of the system. Meanwhile, impedance discontinuity points generated between the circuit board and the socket and impedance discontinuity points generated between the socket and the cable assembly are reduced, and SI performance is improved, thereby improving bandwidth of signal transmission.

In an embodiment, the first avoidance port and the second avoidance port in all the foregoing embodiments may be unplated through holes, while the transition hole, the first conductive interface, and the second conductive interface may be plated through holes, which may be set according to actual needs, and are not specifically limited herein.

It should be noted that the numbers of first connecting members, second connecting members, and cables in the cable assembly in all the foregoing embodiments are not limited. For example, as shown in FIG. 10, there may be one or more first connecting members 120, second connecting members 130, and cables 110, which will not be enumerated herein. Similarly, the numbers of first conductive interfaces and second conductive interfaces in the circuit board are not limited. For example, there may be one or more first conductive interfaces and second conductive interfaces, which are not listed herein one by one.

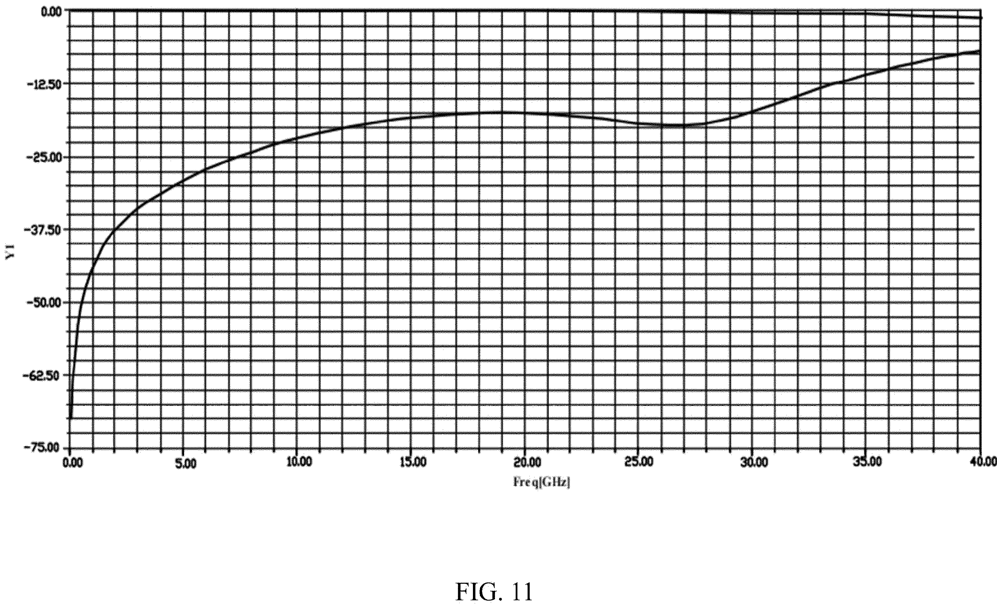

For the connection structure provided in the foregoing embodiment, the performance of the connection structure in the present disclosure is tested below by way of an example:
In an embodiment, when the finished hole size of the first conductive interface and the finished hole size of the second conductive interface are 0.3 mm, and the conductive materials in the first conductive interface and the second conductive interface are both fuzz buttons, signal transmission bandwidth of the connection structure can reach 40 GHz, as shown in FIG. 11, where a horizontal axis indicates a frequency(GHz), a vertical axis indicates an amplitude (dB), and a difference between two curves is greater than 5 dB between frequencies of 0 GHz and 40 GHz.

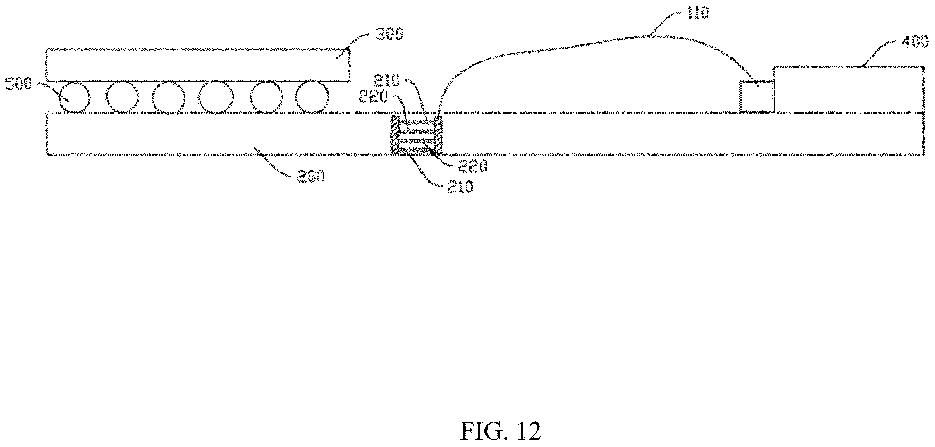

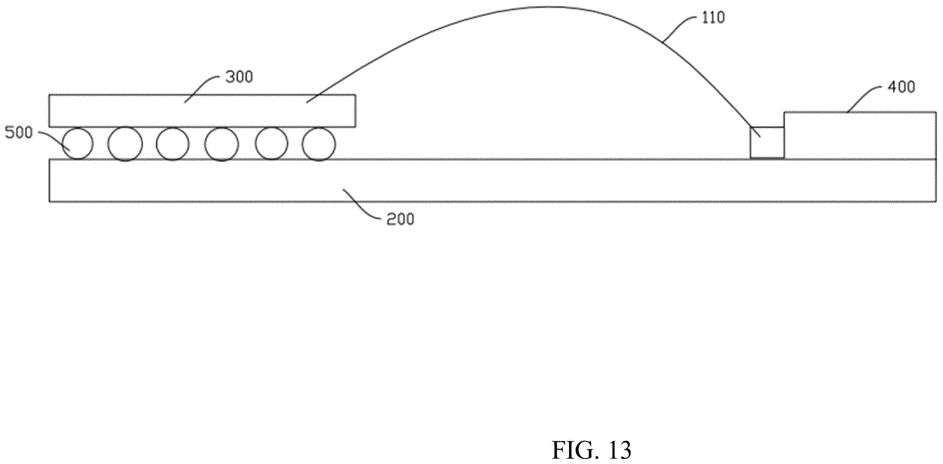

It should be noted that the cable 110 in the cable assembly 100 may be, but not limited to, connected to the circuit board 200 (as shown in FIG. 12), or may be connected to a chip 300 (as shown in FIG. 13), for example, an Application-Specific Integrated Circuit (ASIC) chip, which is not specifically limited herein. It can be understood that when the cable assembly is connected to the chip, the chip has the same inventive concept as the circuit board in all the foregoing embodiments, and therefore has the same implementation principles and technical effects. Details are not described herein again. As shown in FIG. 12, a cable 110 in a pluggable cable connector 400 in an optical module is directly connected to a circuit board 200, and a chip 300 may be connected to the circuit board 200 by a solder ball 500. Alternatively, as shown in FIG. 13, a cable 110 in a pluggable cable connector 400 in an optical module is directly connected to a chip 300, and the chip 300 may be connected to a circuit board 200 by a solder ball 500.

In addition, an embodiment of the present disclosure provides an electronic device. The electronic device includes the cable assembly in the foregoing embodiment, or includes the circuit board in the foregoing embodiment, or includes the connection structure in the foregoing embodiment. Therefore, the electronic device has the beneficial effects brought by the cable assembly, the circuit board, or the connection structure in any one of the foregoing embodiments. To be specific, the elastically-deformable second connecting portion is arranged on the first connecting member of the cable assembly, and the elastically-deformable fourth connecting portion is arranged on the second connecting member, such that after the second connecting portion is elastically connected to the first conductive interface of the circuit board and the fourth connecting portion is elastically connected to the second conductive interface of the circuit board, the cable assembly can be detachable from the circuit board, which reduces production costs of maintenance and rework. In addition, the first connecting member and the second connecting member can be directly connected to the circuit board for signal transmission without having to arrange a socket on the cable assembly, which reduces the height of the cable assembly, to facilitate heat dissipation of the system. Meanwhile, impedance discontinuity points generated between the circuit board and the socket and impedance discontinuity points generated between the socket and the cable assembly are reduced, thereby improving signal transmission bandwidth of the electronic device.

The embodiments of the present disclosure include at least the following beneficial effects: The elastically-deformable second connecting portion is arranged on the first connecting member, and the elastically-deformable fourth connecting portion is arranged on the second connecting member, such that after the second connecting portion is elastically connected to the first conductive interface of the circuit board and the fourth connecting portion is elastically connected to the second conductive interface of the circuit board, the cable assembly can be detachable from the circuit board, which reduces production costs of maintenance and rework. In addition, the first connecting member and the second connecting member can be directly connected to the circuit board for signal transmission without having to arrange a socket on the cable assembly, which reduces the height of the cable assembly, to facilitate heat dissipation of the system. Meanwhile, impedance discontinuity points generated between the circuit board and the socket and impedance discontinuity points generated between the socket and the cable assembly are reduced, thereby improving bandwidth of signal transmission.

Those having ordinary skills in the art can understand that all or some of the steps in the methods disclosed above and the functional modules/units in the system and the apparatus can be implemented as software, firmware, hardware, and appropriate combinations thereof. Some or all physical components may be implemented as software executed by a processor, such as a central processing unit, a digital signal processor, or a microprocessor, or as hardware, or as an integrated circuit, such as an application-specific integrated circuit. Such software may be distributed on a computer-readable medium, which may include a computer storage medium (or non-transitory medium) and a communication medium (or transitory medium). As is known to those having ordinary skills in the art, the term "computer storage medium" includes volatile and nonvolatile, removable and non-removable media implemented in any method or technology for storage of information (such as computer-readable instructions, data structures, program modules, or other data). The computer storage medium includes, but not limited to, a Random Access Memory (RAM), a Read-Only Memory (ROM), an Electrically Erasable Programmable Read-Only Memory (EEPROM), a flash memory or other memory technology, a Compact Disc Read-Only Memory (CD-ROM), a Digital Versatile Disc (DVD) or other optical storage, a cassette, a magnetic tape, a magnetic disk storage or other magnetic storage device, or any other medium which can be used to store the desired information and can be accessed by a computer. In addition, as is known to those having ordinary skills in the art, the communication medium typically includes computer-readable instructions, data structures, program modules, or other data in a modulated data signal such as a carrier or other transport mechanism, and can include any information delivery medium.

## Claims

1. A cable assembly, comprising:
a cable, comprising a signal line and a shielding layer;
a first connecting member, comprising a first connecting portion and a second connecting portion, wherein the first connecting portion is connected to the signal line, the second connecting portion is elastically deformable, and the second connecting portion is configured to be elastically connected to a circuit board provided with a first conductive interface; and
a second connecting member, comprising a third connecting portion and a fourth connecting portion, wherein the third connecting portion is connected to the shielding layer, the fourth connecting portion is elastically deformable, and the fourth connecting portion is configured to be elastically connected to the circuit board provided with a second conductive interface.

2. The cable assembly of claim 1, wherein the second connecting portion comprises a first connecting sub-portion and a second connecting sub-portion which are arranged oppositely, the fourth connecting portion comprises a third connecting sub-portion and a fourth connecting sub-portion which are arranged oppositely, and the first connecting sub-portion, the second connecting sub-portion, the third connecting sub-portion, and the fourth connecting sub-portion are all elastically deformable.

3. The cable assembly of claim 2, wherein when the first connecting sub-portion and the second connecting sub-portion are in an elastically-deformed state, a distance between the first connecting sub-portion and the second connecting sub-portion is shortened, and when the third connecting sub-portion and the fourth connecting sub-portion are in an elastically-deformed state, a distance between the third connecting sub-portion and the fourth connecting sub-portion is shortened.

4. The cable assembly of claim 1, wherein the second connecting portion is provided with a first elastic structure communicated with the first connecting portion, and the fourth connecting portion is provided with a second elastic structure communicated with the third connecting portion, and when the second connecting portion is elastically connected to the first conductive interface and the fourth connecting portion is elastically connected to the second conductive interface, the first elastic structure and the second elastic structure are both in an elastically-deformed state.

5. The cable assembly of claim 1, wherein the cable assembly further comprises a fixing piece, the fixing piece comprises a first fixing portion and a second fixing portion, the first fixing portion is connected at a connection between the first connecting portion and the signal line, and the second fixing portion is connected at a connection between the third connecting portion and the shielding layer.

6. The cable assembly of claim 1, 2, or 4, wherein the second connecting portion and the fourth connecting portion are both provided with a guide structure, and the guide structure is chamfered or tapered.

7. A circuit board, comprising:
a first conductive interface, configured to be connected to the cable assembly of any one of claims 1 to 6; and
a second conductive interface, configured to be connected to the cable assembly.

8. The circuit board of claim 7, wherein the first conductive interface is filled with an elastically-deformable conductive material, and the first conductive interface is elastically connected to the cable assembly through the conductive material; and
the second conductive interface is filled with the conductive material, and the second conductive interface is elastically connected to the cable assembly through the conductive material.

9. The circuit board of claim 7, wherein the circuit board is provided with an avoidance groove, and the first conductive interface and the second conductive interface are both connected to the avoidance groove.

10. The circuit board of claim 9, wherein the avoidance groove comprises a first avoidance port and a second avoidance port, the first conductive interface is connected to the first avoidance port, and the second conductive interface is connected to the second avoidance port.

11. A connection structure, comprising:
a cable assembly, comprising a cable, a first connecting member, and a second connecting member, wherein the cable comprises a signal line and a shielding layer, the first connecting member comprises a first connecting portion and a second connecting portion, the first connecting portion is connected to the signal line, the second connecting portion is elastically deformable, the second connecting member comprises a third connecting portion and a fourth connecting portion, the third connecting portion is connected to the shielding layer, and the fourth connecting portion is elastically deformable; and
a circuit board, comprising a first conductive interface and a second conductive interface, wherein:
the first conductive interface is elastically connected to the second connecting portion, and the second conductive interface is elastically connected to the fourth connecting portion.

12. An electronic device, comprising the cable assembly of any one of claims 1 to 6, or comprising the circuit board of any one of claims 7 to 10, or comprising the connection structure of claim 11.
